(19) Europäisches Patentamt
European Patent Office
Office européen des brevets

(11) **EP 4 769 879 A1**

(12) **EUROPEAN PATENT APPLICATION**
published in accordance with Art. 153(4) EPC

(43) Date of publication:
**01.07.2026 Bulletin 2026/27**

(21) Application number: **24945740.9**

(22) Date of filing: **05.11.2024**

(51) International Patent Classification (IPC):
**H02J 7/00** (2026.01)      **G01R 31/396** (2019.01)
**G01R 31/392** (2019.01)

(52) Cooperative Patent Classification (CPC):
**G01R 31/392; G01R 31/396; H02J 7/00**

(86) International application number:
**PCT/KR2024/017274**

(87) International publication number:
**WO 2025/263695 (26.12.2025 Gazette 2025/52)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **17.06.2024 KR 20240078324**

(71) Applicant: **LG Energy Solution, Ltd.
Seoul 07335 (KR)**

(72) Inventors:
• **NAM, Gi Min
Daejeon 34122 (KR)**

• **LEE, Kangwook
Daejeon 34122 (KR)**
• **KANG, Hyeyeon
Daejeon 34122 (KR)**
• **KIM, Hyeongseok
Daejeon 34122 (KR)**
• **LEE, Hojin
Daejeon 34122 (KR)**
• **HWANG, Taehyun
Daejeon 34122 (KR)**

(74) Representative: **Plasseraud IP
104 Rue de Richelieu
CS92104
75080 Paris Cedex 02 (FR)**

(54) **ELECTRONIC DEVICE, AND METHOD FOR DETERMINING FAST CHARGING PATTERN OF BATTERY CELL**

(57)    Disclosed are a method for determining a fast charging pattern of a battery cell and an electronic device performing same, the method comprising the steps of: setting charging conditions including a charging current set including a plurality of charging currents of a battery cell, a total charging capacity of the battery cell, and a total charging duration of the battery cell; determining a first set of individual charging durations including a plurality of individual charging durations respectively corresponding to the plurality of charging currents satisfying the charging conditions; determining a charging sequence of the plurality of charging currents corresponding to the first set of individual charging durations; determining, on the basis of the charging sequence of the plurality of charging currents, a second set of individual charging durations including a plurality of individual charging durations in which an increase in voltage of the battery cell after charging is minimized; and determining the charging sequence and the second set of individual charging durations as a fast charging pattern of the battery cell.

EP 4 769 879 A1

**(Cont. next page)**

# FIG. 2

Start

↓

Set charging condition including charging current set including plurality of charging currents of battery cell, full charge capacity of battery cell and total charge time of battery cell — S210

↓

Determine first individual charging time period set including plurality of individual charging time periods corresponding to each of plurality of charging currents that satisfy charging conditions — S220

↓

Determine charging order of plurality of charging currents corresponding to first individual charging time period set — S230

↓

Based on charging order of plurality of charging currents, determine second individual charging time period set including plurality of individual charging time periods in which voltage increase value of battery cell is minimized — S240

↓

Determine charging order and second individual charging time period set as fast charging pattern of battery cell — S250

↓

End

## Description

### Technical Field

The present disclosure relates to a method of determining a fast charging pattern of a battery cell and an electronic device performing the same.

### Background Art

As the usage environment of lithium ion batteries becomes more diverse, the importance of fast charging technology is increasing, which allows users to quickly complete a charge and operate the battery instead of waiting for a long time to charge by charging the battery in a short period of time. The key to fast charging technology for lithium ion batteries lies in high efficiency and stability. Research is ongoing to find ways to charge batteries at a faster rate than existing charging methods while minimizing problems such as heat generation and shortened battery life during the process. Regarding fast charging technology for lithium ion batteries, based on the results obtained through 3-electrode experiments, the main method is to charge the battery first with a high current and then gradually charge the battery with a lower current, and various studies are being conducted on more optimized fast charging methods.

### Detailed Description of the Invention

### Technical Goals

Provided according to example embodiments is a method of determining a charging pattern of a battery cell and an electronic device performing the same. Specifically, explored and provided is a charging pattern for fast charging that minimizes battery cell degradation through a single fast charge when a plurality of charging currents used for fast charging of a battery cell, the full charge capacity of the battery cell and the total charge time of the battery cell are limited, in other words, under the limited fast charging conditions.

The technical tasks to be achieved by the present example embodiments are not limited to the technical tasks described above, and other technical tasks may be inferred from the following example embodiments.

### Technical solutions

According to an example embodiment, a method of determining a charging pattern of a battery cell, may include setting, by an electronic device, charging conditions including a charging current set including a plurality of charging currents of the battery cell, a full charge capacity of the battery cell and a total charge time of the battery cell, determining a first individual charging time period set including a plurality of individual charging time periods corresponding to each of the plurality of charging currents satisfying the charging conditions, determining a charging order of the plurality of charging currents corresponding to the first individual charging time period set, based on the charging order of the plurality of charging currents, determining a second individual charging time period set including a plurality of individual charging time periods in which a voltage increase value of the battery cell after charging becomes minimum, and determining the charging order and the second individual charging time period set as the charging pattern of the battery cell.

The determining the first individual charging time period set may include obtaining a set of the plurality of individual charging time periods in order for a value, which is obtained by adding values obtained by multiplying a predetermined charging current included in the plurality of charging currents of the battery cell and a predetermined charging time period corresponding to the predetermined charging current, to be equal to the full charge capacity of the battery cell, and in order for a sum of predetermined charging time periods to be equal to the total charge time of the battery cell, and determining a set of individual charging time periods in which a minimum number of times an anode voltage of the battery cell satisfies a threshold voltage in an entire charging process, from sets of the plurality of individual charging time periods.

The determining the charging order of the plurality of charging currents corresponding to the first individual charging time period set may include, determining as the charging order, an order of a charging current set in which a number of times an anode voltage of the battery cell satisfies is minimum a threshold voltage in an entire charging process according to a charging current value corresponding to the first individual charging time period set.

The method according to an example embodiment may further include, after charging is performed according to the charging pattern of the battery cell, obtaining information on capacity degradation of the battery cell and information on increase of internal resistance of the battery cell.

The method according to an example embodiment may further include, based on the information on the capacity degradation of the battery cell and the information on the increase of the internal resistance of the battery cell, setting charging conditions including the charging current set including the plurality of charging currents of the battery cell after charging is performed, the full charge capacity of the battery cell after the charging is performed and the total charge time of the battery cell after the charging is performed, determining a third individual charging time period set including a plurality of individual charging time periods corresponding to each of the plurality of charging currents satisfying the charging conditions, determining a charging order of the plurality of charging currents corresponding to the third individual charging time period set, based on the charging order of the plurality of charging currents, determining a fourth individual charging time period set in which a charging voltage of the battery cell after the charging is performed becomes minimum and that includes a plurality of individual charging time periods, and determining the charging order and the fourth individual charging time period set as the charging pattern of the battery cell after the charging is performed.

The setting the charging conditions may include generating a matrix of which elements are values of the plurality of charging currents and a matrix of which elements are a value of the full charge capacity and a value of the total charge time, and determining first charging current sets may include arbitrarily changing an order of each element of the matrix of which elements are the values of the plurality of charging currents, and determining first charging current sets including a plurality of individual charging time periods corresponding to each charging current of a changed order.

Each of the plurality of charging currents included in the charging current set may include a different value.

The charging conditions may be determined based on at least one of internal temperature of the battery cell, an initial state of charge (SoC) of the battery cell, and internal resistance of the battery cell.

A non-transitory computer-readable recording medium may have a program for executing the method on a computer.

According to an example embodiment, an electronic device performing a method of determining a charging pattern of a battery cell may include a memory configured to store instructions and a processor connected to the memory, wherein the processor is configured to set charging conditions including a charging current set including a plurality of charging currents of the battery cell, full charge capacity of the battery cell and total charge time of the battery cell, determine a first individual charging time period set including a plurality of individual charging time periods corresponding to each of the plurality of charging currents satisfying the charging conditions, determine a charging order of the plurality of charging currents corresponding to the first individual charging time period set, based on the charging order of the plurality of charging currents, determine a second individual charging time period set including a plurality of individual charging time periods in which a voltage increase value of the battery cell becomes minimum, and determine the charging order and the second individual charging time period set as the charging pattern of the battery cell.

Additional aspects of example embodiments will be set forth in part in the description which follows and, in part, will be apparent from the description, or may be learned by practice of the disclosure.

### Effects of the Invention

According to the example embodiments, one or more of the following effects may be expected.

According to the example embodiments, it is possible to obtain a plurality of individual charging time periods that satisfy charging conditions including a charging current set including a plurality of charging currents of a battery cell, full charge capacity of the battery cell and total charge time of the battery cell.

Further, according to the example embodiments, it is possible to determine an optimal fast charging pattern by which fast charging of the battery cell minimizes the decrease in anode voltage, and the lifespan decrease and degradation of the battery cell due to fast charging are reduced.

Further, according to the example embodiments, it is possible to continuously reflect the optimal fast charging current pattern according to changed battery cell specification by obtaining information on capacity degradation of a battery cell after fast charging is completed and information on increase of the internal resistance.

Effects of the present disclosure are not limited to those described above, and other effects may be made apparent to those skilled in the art from the following description.

### Brief Description of Drawings

FIG. 1 illustrates the interconnection of electronic devices that determine a fast charging pattern of a battery cell according to an example embodiment.
FIG. 2 is a flowchart of a method for determining a fast charging pattern of a battery cell according to an example embodiment.
FIG. 3a and FIG. 3b are drawings for explaining operations of determining a first individual charging time period set in a method of determining a fast charging pattern of a battery cell, according to an example embodiment.
FIG. 4a and FIG. 4b are drawings for explaining operations for determining a charging order of a plurality of charging currents in a method of determining a fast charging pattern of a battery cell, according to an example embodiment.

FIG. 5a and FIG. 5b are drawings for explaining operations of determining a charging order and a second individual charging time period set as a fast charging pattern of a battery cell in a method of determining a fast charging pattern of a battery cell, according to an example embodiment.

FIG. 6a to FIG. 6c are drawings for explaining the effect of a method for determining a fast charging pattern of a battery cell according to an example embodiment.

FIG. 7 is a block diagram showing the configuration of an electronic device that determines a fast charging pattern of a battery cell according to an example embodiment.

## Mode for Carrying Out the Invention

Terms used in the example embodiments are selected from currently widely used general terms when possible while considering the functions in the present disclosure. However, the terms may vary depending on the intention or precedent of a person skilled in the art, the emergence of new technology, and the like. Further, in certain cases, there are also terms arbitrarily selected by the applicant, and in the cases, the meaning will be described in detail in the corresponding descriptions. Therefore, the terms used in the present disclosure should be defined based on the meaning of the terms and the contents of the present disclosure, rather than the simple names of the terms.

Throughout the specification, when a part is described as "comprising or including" an element, it does not exclude another element but may further include another element unless otherwise stated.

Expression "at least one of a, b and c" described throughout the specification may include "a alone," "b alone," "c alone," "a and b," "a and c," "b and c" or "all of a, b and c."

In the present disclosure, a "terminal" may be implemented as, for example, a computer or a portable terminal capable of accessing a server or another terminal through a network. Here, the computer may include, for example, a notebook, a desktop computer, and/or a laptop computer which are equipped with a web browser. The portable terminal may be a wireless communication device ensuring portability and mobility, and include (but is not limited to) any type of handheld wireless communication device, for example, a tablet PC, a smartphone, a communication-based terminal such as international mobile telecommunication (IMT), code division multiple access (CDMA), W-code division multiple access (W-CDMA), long term evolution (LTE), or the like.

Hereinafter, example embodiments of the present disclosure will be described in detail with reference to the accompanying drawings so that those of ordinary skill in the art to which the present disclosure pertains may easily implement them. However, the present disclosure may be implemented in multiple different forms and is not limited to the example embodiments described herein.

Hereinafter, example embodiments according to the technical idea of the present disclosure will be described with reference to the attached drawings.

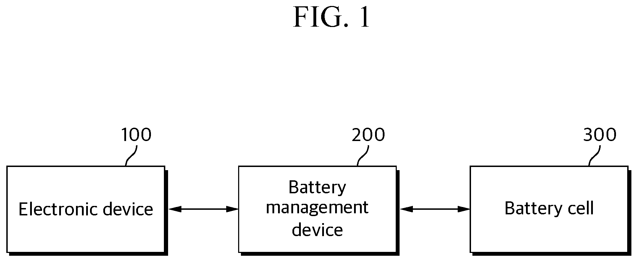

FIG. 1 illustrates the interconnection of electronic devices that determine the impedance of a target battery cell according to an example embodiment.

Referring to FIG. 1, an electronic device 100 may operate in conjunction with a battery management device 200 that manages battery cells 300. Here, the battery cells 300 may include a battery cell that is subject to fast charging. Meanwhile, FIG. 1 illustrates only the elements relevant to this example embodiment. Therefore, it would be understood by those skilled in the art related to this example embodiment that other general elements may be included in addition to the elements illustrated in FIG. 1.

The electronic device 100 is a device that organizes and provides various information. The electronic device 100 may perform various operations to set charging conditions for fast charging of battery cells, and determine a first individual charging time period set that satisfies a specific condition among a plurality of sets of individual charging time periods corresponding to each of a plurality of charging currents that satisfy the charging conditions. The electronic device 100 may perform a simulation may be performed to determine the optimal charging time period corresponding to the first individual charging time period set, and provide a result thereof. Further, the electronic device 100 may additionally perform simulations on charging results according to sets of a plurality of individual charging time periods that satisfy the charging conditions when the determined optimal charging time period is fixed. The electronic device 100 may additionally perform various operations to determine a second individual charging time period set that satisfies certain conditions among sets of a plurality of individual charging time periods. Through this, the electronic device 100 may perform the entire process of determining a fast charging pattern taking into account the conditions of a particular battery cell.

The battery management device 200 may include one or more sensors for measuring parameters of the battery cell 300, such as current, voltage, SoC, internal resistance and internal temperature. The battery management device 200 may include memory and a processor for various operations. In other words, the battery management device 200 operates based on the memory and the processor similarly to the electronic device 100, but additionally includes a sensor to measure and calculate parameters of the battery cell 300. Alternatively, the battery management device 200 may perform all of the operations and simulations performed by the electronic device 100, as briefly described above.

Here, the electronic device 100 and the battery management device 200 may be completely separate and independent objects. However, the electronic device 100 and the battery management device 200 may exist only conceptually separately within a single device or system. In other words, a single computing device with control functions for battery cells may perform both the functions of the electronic device 100 and the battery management device 200 described below. Therefore, such example embodiments are also considered to fall within the scope of the present disclosure.

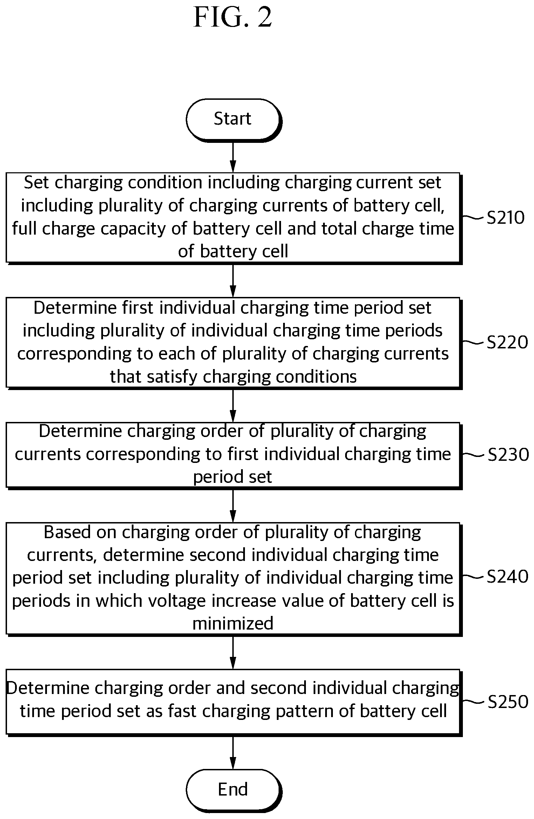

Hereinafter, a battery analysis method according to an example embodiment of the present disclosure will be described with reference to FIG. 2.

FIG. 2 is a flowchart of a method for determining a fast charging pattern of a battery cell according to an example embodiment.

Referring to FIG. 2, in operation S210, the electronic device 100 according to an example embodiment may set charging conditions including a charging current set including a plurality of charging currents of a battery cell, the full charge capacity of the battery cell and the total charge time of the battery cell. In this case, the charging conditions may be determined based on at least one of the internal temperature of the battery cell, the initial SoC of the battery cell and the internal resistance of the battery cell, and may also be determined based on electrochemical parameters from electrochemical simulations on other cloud battery management devices or on-board battery management devices. Each of the charging current set including a plurality of charging currents of a battery cell, the full charge capacity of the battery cell and the total charge time of the battery cell may be determined based on the user requirements for using the battery cell. The electronic device 100 according to an example embodiment may generate a matrix having values of a plurality of charging currents as elements and a matrix having a value of the full charge capacity and a value of the total charge time as elements. In this case, a row or a column whose elements include values of a plurality of charging currents may correspond to a charging current set. In this case, a row or column whose elements are the values of a plurality of individual charging time periods corresponding to each of the plurality of charging currents. In this case, each of the plurality of charging currents included in the charging current set may have different values. Further, the number of plurality of charging currents included in the plurality of charging currents set and the number of individual charging time periods may be the same.

In operation S220, the electronic device 100 according to an example embodiment may determine a first individual charging time period set including a plurality of individual charging time periods corresponding to each of a plurality of charging currents that satisfy the charging conditions. In operation S220, the electronic device 100 may obtain a plurality of sets of individual charging time periods in order for the sum of the values obtained by multiplying specific charging currents included in the charging currents of the battery cell by a specific charging time period corresponding to the specific charging currents to be equal to the full charge capacity of the battery cell, and in order for the sum of all specific charging time periods to be equal to the total charge time of the battery cell.

In this case, the first individual charging time period set including a plurality of individual charging time periods corresponding to each of a plurality of charging currents according to the charging current set including a plurality of charging currents, the full charge capacity of the battery cell and the total charge time of the battery cell may be determined based on following Equation 1.

[Equation 1]

$$
\begin{bmatrix} i1 & i2 & i3 & i4 & \dots & i6 & i7 & i8 & in \\ 1 & 1 & 1 & 1 & \dots & 1 & 1 & 1 & 1 \end{bmatrix} \times \begin{bmatrix} x1 \\ x2 \\ x3 \\ x4 \\ \dots \\ x6 \\ x7 \\ x8 \\ xn \end{bmatrix} = \begin{bmatrix} Q\,(Q) \\ T\,(s) \end{bmatrix}
$$

In this case, i1 to in may correspond to a plurality of charging currents, respectively; x1 to xn may correspond to a plurality of individual charging time periods each corresponding to each of the plurality of charging currents; Q may correspond to the full charge capacity of the battery cell; and T may correspond to the total charge time of the battery cell. In other words, the number of each of the plurality of charging currents and the number of plurality of individual charging time periods may be equal. In this case, the first row of the first matrix on the left side of Equation 1 may correspond to a charging current set corresponding to a row whose elements include values of the plurality of charging currents. In this case, the first column of the second matrix on the left side of Equation 1 may correspond to a set of individual charging time periods corresponding to a column whose elements include values of the plurality of individual charging time periods corresponding to each of the plurality of charging currents. For example, in Equation 1, the number of unknowns x1 to xn is n (for example, n is a natural number greater than 2), and there are two formulas: one for the full charge capacity of the battery cell and one for the total charge time of the battery cell. Thus, there may be many values of x1 to xn that satisfy Equation 1 provided that the values of x1 to xn are positive. In operation S220, in order to determine the charging current set that will serve as the basis for optimization, the electronic device 100 according to an example embodiment may arbitrarily determine the order of each element of a matrix having a plurality of charging currents values as elements. The electronic device 100 may obtain arbitrary particular solution that satisfies the matrix relation of Equation 1, and obtain the homogeneous solution according to the null space of the first matrix on the left side of Equation 1 and the electronic device 100 may obtain a complete solution by linearly combining any particular solution and a homogeneous solution. The electronic device 100 may arbitrarily determine the order of each element of the matrix as above, and determine a critical number of solutions (for example, 100,000) by repeating the process of finding a homogeneous solution, a particular solution and a complete solution a critical number of times (for example, 100,000 times). In other words, in operation S220, the electronic device 100 according to an example embodiment may determine a threshold number or more of sets of individual charging time periods, each of which includes a plurality of individual charging time periods corresponding to a plurality of charging currents. In operation S220, the electronic device 100 according to an example embodiment may perform fast charging for a plurality of individual charging time periods corresponding to each of the plurality of obtained charging currents and then determine a set of individual charging time periods corresponding to the minimum number of times that the anode voltage of the battery cell satisfies the threshold voltage (for example, 0 V) as the first individual charging time period set.

For example, when fast charging a battery cell, when described is the case where the full charge capacity of 13306Q is charged using charging currents of 5.2A, 4.8A, 4.32A, 3.84A, 3.36A, 2.88A, 2.4 A, 1.92 A and 1.44 A, and the total charge time, which is the sum of individual charging time periods corresponding to each charging current, is 3600(s), Equation 1 may be expressed as Equation 2 below.

[Equation 2]

$$\begin{bmatrix} 5.2 & 4.8 & 4.32 & 3.84 & 3.36 & 2.88 & 2.4 & 1.92 & 1.44 \\ 1 & 1 & 1 & 1 & 1 & 1 & 1 & 1 & 1 \end{bmatrix} \times \begin{bmatrix} x1 \\ x2 \\ x3 \\ x4 \\ x5 \\ x6 \\ x7 \\ x8 \\ x9 \end{bmatrix} = \begin{bmatrix} 13306\,(Q) \\ 3600\,(s) \end{bmatrix}$$

Through the process of operation S220, individual charge sets of unknown numbers x1 to xn satisfying Equation 2 may be determined as Equation 3 below.

[Equation 3]

$$\begin{bmatrix} x1 \\ x2 \\ x3 \\ x4 \\ x5 \\ x6 \\ x7 \\ x8 \\ x9 \end{bmatrix} = \begin{bmatrix} 145 \\ 1425 \\ 260 \\ 270 \\ 280 \\ 290 \\ 300 \\ 310 \\ 320 \end{bmatrix} (X1) \quad or \quad \begin{bmatrix} 145 \\ 1775 \\ 60 \\ 120 \\ 180 \\ 240 \\ 300 \\ 360 \\ 420 \end{bmatrix} (X2)$$

In another example embodiment, when the electronic device 100 arbitrarily determines the order of each element of a matrix whose elements are a plurality of charging currents, Equation 1 may be expressed as Equation 4 below.

[Equation 4]

$$\begin{bmatrix} 4.8 & 4.32 & 2.88 & 2.4 & 1.44 & 3.36 & 5.2 & 3.84 & 1.92 \\ 1 & 1 & 1 & 1 & 1 & 1 & 1 & 1 & 1 \end{bmatrix} \times \begin{bmatrix} x1 \\ x2 \\ x3 \\ x4 \\ x5 \\ x6 \\ x7 \\ x8 \\ x9 \end{bmatrix} = \begin{bmatrix} 13306\ (Q) \\ 3600\ (s) \end{bmatrix}$$

Through the process of operation S220, the individual charge sets of unknowns x1 to xn satisfying Equation 4 may be determined as Equation 5 below.

[Equation 5]

$$\begin{bmatrix} x1 \\ x2 \\ x3 \\ x4 \\ x5 \\ x6 \\ x7 \\ x8 \\ x9 \end{bmatrix} = \begin{bmatrix} 1.5 \\ 1694.5 \\ 68 \\ 136 \\ 204 \\ 272 \\ 340 \\ 408 \\ 476 \end{bmatrix} (X3)\ or\ \begin{bmatrix} 65 \\ 1645 \\ 105 \\ 160 \\ 215 \\ 270 \\ 325 \\ 380 \\ 435 \end{bmatrix} (X4)$$

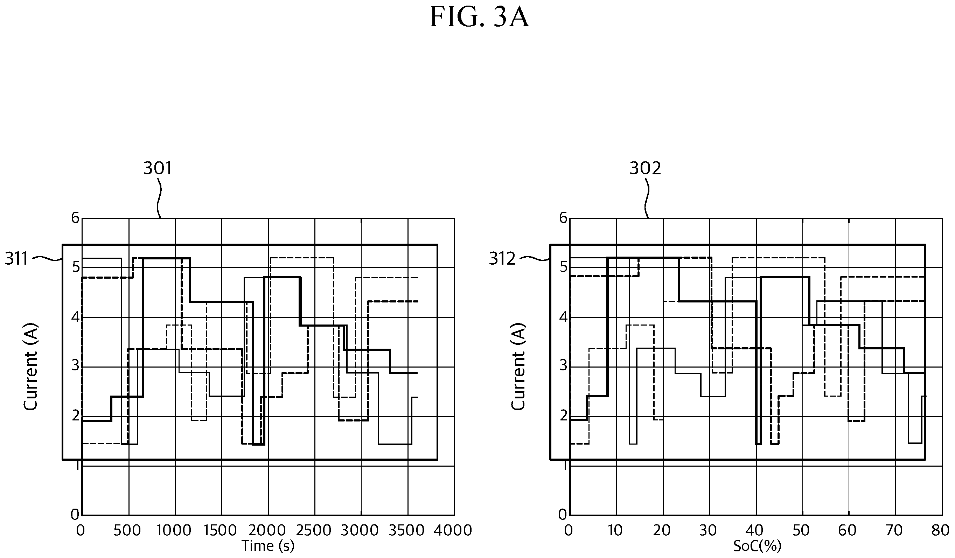

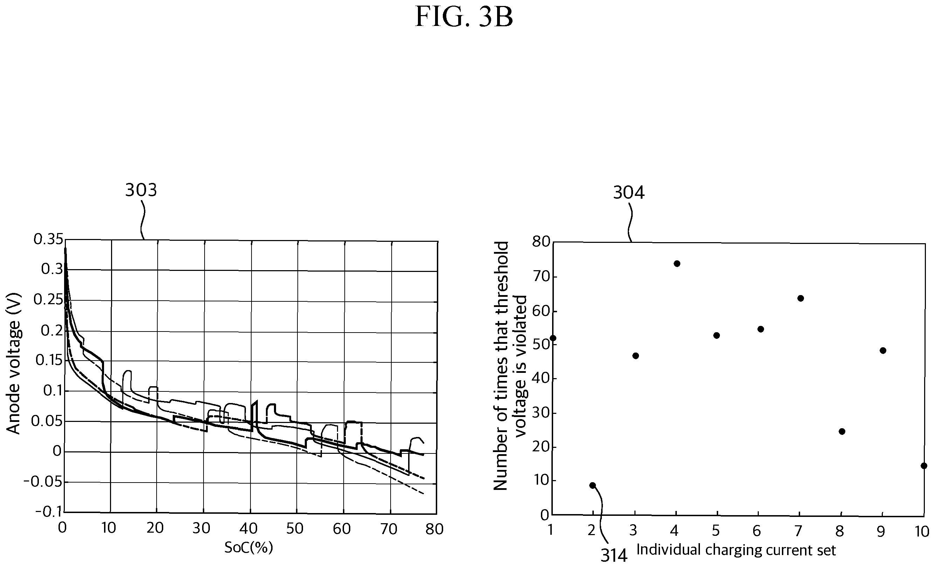

In this case, the two different matrices (X1 and X2) on the left side of Equation 3 and the two different matrices (X3 and X4) on the left side of Equation 5 may both correspond to individual charging time period sets. However, the cases of the matrices whose elements are the plurality of charging currents in Equation 2 to Equation 5 are mere example embodiments. When a total of nine charging currents are used for charging, there may be 9! Matrices, and there may be an infinite number of sets of individual charging time periods that satisfy this. The process of determining the first individual charging time period set among the mentioned individual charging time period sets is specifically described in FIG. 3a and FIG. 3b below.

In operation S230, the electronic device 100 according to an example embodiment may determine a charging order of the plurality of charging currents corresponding to the first individual charging time period set. For example, even if charging is performed for the same plurality of charging currents and the corresponding plurality of individual charging time periods, the efficiency of fast charging of a battery cell may vary depending on the charging current and order used for fast charging, and in operation S230, the electronic device 100 may determine the order of charging current of battery cells with optimal efficiency. In this case, when the number of plurality of charging currents is N, the total number of charging orders may be defined as N!. In operation S230, the electronic device 100 may perform fast charging for a plurality of individual charging time periods corresponding to each of the plurality of charging currents by arbitrarily changing the charging order of the plurality of charging currents while maintaining the first individual charging time period set the same, and then the electronic device 100 may determine the charging order corresponding to the minimum number of times that the anode voltage of the battery cell satisfies the threshold voltage (for example, 0 V).

In operation S240, based on the charging order of the plurality of charging currents, the electronic device 100 according to an example embodiment may determine a second individual charging time period set including a plurality of individual charging time periods in which a voltage increase value of a battery cell after charging is minimized. For example, the electronic device 100 according to an example embodiment may perform charging by changing only the plurality of individual charging time periods corresponding to each of the plurality of charging currents while maintaining the same charging order determined in preceding operation S230, and determine a second individual charging time period set including a plurality of individual charging time periods in which the voltage increase value of the battery cell after charging is minimum in order for the anode voltage of the battery cell to fall as little as possible below 0 V compared to the LI reference potential where lithium plating occurs based on the charging order of the plurality of charging currents. In another example embodiment, the electronic device 100 may determine a second individual charging time period set including a plurality of individual charging time periods in which the cathode voltage increase value of the battery cell after charging is minimum. When the anode voltage decrease of the battery cell after charging is minimal or when the cathode voltage increase value of the battery cell after charging is minimal, the voltage increase value of the battery cell after charging becomes minimum. Thus, the electronic device 100 according to an example embodiment may determine a second individual charging time period set corresponding to a case where a voltage increase value of a battery cell after charging is less than a threshold voltage. In this case, the second individual charging time period set is usually different from the first individual charging time period set discussed in operation S220, but the second individual charging time period set including individual charging time periods in which the voltage increase value of the battery cell after charging is minimum based on a charging order determined based on the first individual charging time period set may be identical to the first individual charging time period set.

In operation S250, the electronic device 100 according to an example embodiment may determine the charging order and the second individual charging time period set as a fast charging pattern of the battery cell. The electronic device 100 according to an example embodiment may determine a fast charging pattern of the battery cell by using a plurality of individual charging time periods included in the second individual charging time period set to charge the battery cell corresponding to each charging order of the plurality of charging currents determined in operation S230. After charging is performed according to the fast charging pattern of the battery cell, the electronic device 100 according to an example embodiment may further perform operations of obtaining information on the capacity degradation of a battery cell and information on increase of the internal resistance of the battery cell. After then, the electronic device may perform the preceding operations to determine a fast charging pattern suitable for the changed specifications of the battery cell after fast charging of the battery cell. In other words, based on the information on the capacity degradation of the battery cell and the information on the increase of the internal resistance of the battery cell, the electronic device 100 according to an example embodiment may set charging conditions including a charging current set including a plurality of charging currents of the battery cell after charging is performed, a full charge capacity of the battery cell after charging is performed, and a total charge time of the battery cell after charging is performed. The electronic device 100 according to an example embodiment may determine a third individual charging time period set including a plurality of individual charging time periods corresponding to each of a plurality of charging currents that satisfy the charging conditions, determine a charging order of the plurality of charging currents corresponding to the third individual charging time period set, determine a fourth individual charging time period set, based on the charging order of the plurality of charging currents, in which the charging voltage of the battery cell after charging is performed is minimum and that includes a plurality of individual charging time periods, and determine the charging order and the fourth individual charging time period set as the fast charging pattern of the battery cell after charging is performed. Through this process, the electronic device 100 may determine, for example, that the capacity degradation of the battery cell (based on the information on capacity degradation of the battery cell) has increased by a critical percentage (for example, 5%) compared to before, or that the internal resistance of the battery cell (based on the information on the increase of the internal resistance of the battery cell) has increased by a critical percentage (for example, 10%), and the electronic device 100 may appropriately determine a fast charging pattern for fast charging according to the specifications of the changed battery cell at the beginning of life (BOL), middle of life (MOL), and end of life (EOL).

FIG. 3a and FIG. 3b are drawings for explaining operations of determining a first individual charging time period set in a method of determining a fast charging pattern of a battery cell, according to an example embodiment.

Referring to FIG. 3a with regard to operation S220 which is described with reference to FIG. 2, identified may be a graph chart 301 of charging current over time and a graph chart 302 of charging current over the SoC of a battery cell when fast charging of the battery cell is performed according to each of a plurality of sets of individual charging time periods including a set of individual charging time periods X1 to X4 as in the preceding example embodiment. Graphs 311 included in the graph chart 301 of charging current and graphs 312 included in the graph chart 302 of charging current according to the SoC of the battery cell represent cases that the charging order of a plurality of charging currents is randomly set, and charging is performed according to a plurality of individual charging time periods corresponding to each of the plurality of charging currents. In this case, the total time, which is from the SoC when fast charging was first started to the SoC when fast charging was ended, and full charge capacity may be the same for all graphs included in the graphs 311 and 312.

Referring to FIG. 3b, identified is a graph chart 303 where the anode voltage according to the SoC of the battery cell until the fast charging is completed. The electronic device 100 according to an example embodiment may determine, as a first individual charging time period set, a set of individual charging time periods that corresponds to the minimum number of times that the anode voltage of a battery cell satisfies the threshold voltage during the entire charging process among a plurality of sets of individual charging time periods. The more overcharging occurs during fast charging of a battery cell, the greater the decrease in the anode voltage and the degree of battery degradation increases, and thus the electronic device 100 according to an example embodiment may determine, as a first individual charging time period set, a set of individual charging time periods that provide the minimum number of times the anode voltage reaches (violates) the threshold voltage (for example, 0 V) during the entire charging process among the set of individual charging time periods. For example, identified referring to FIG. 3b is that when charging is performed with a set 314 of individual charging time periods among the entire sets of individual charging time periods as shown in a chart 304 of the number of threshold voltage reaches according to individual charging current sets, the number of reaches (violation number) between the anode voltage and the threshold voltage is minimum. Therefore, the electronic device 100 according to an example embodiment may determine the set 314 of individual charging time periods as a first individual charging time period set. After then, the electronic device 100 may determine the order of charging current when charging according to the set 314 of individual charging time periods.

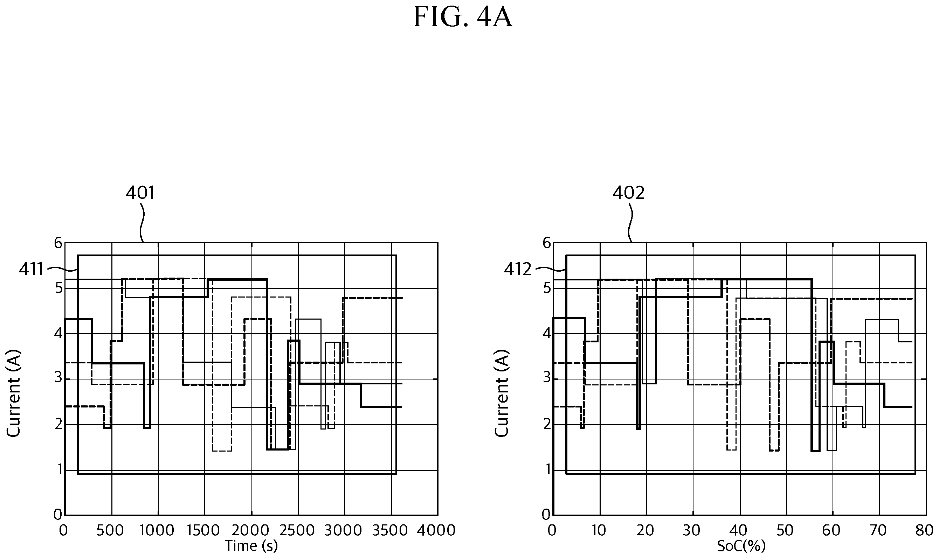

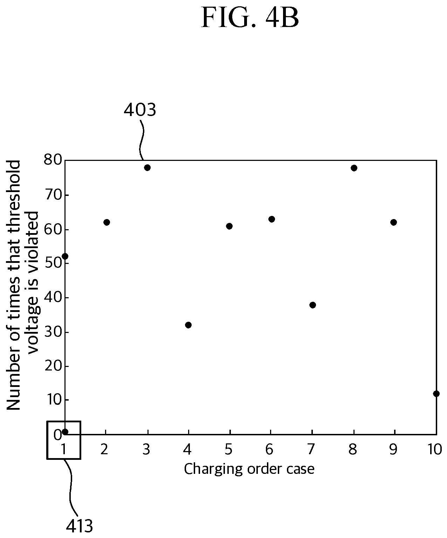

FIG. 4a and FIG. 4b are drawings for explaining operations for determining a charging order of a plurality of charging currents in a method of determining a fast charging pattern of a battery cell, according to an example embodiment.

Referring to FIG. 4a with respect to operation S230 described with reference to FIG. 2 and FIG. 3b, identified is a graph chart 401 of charging current over time and a graph chart 402 of charging current according to the SoC of a battery cell when the fast charging of the battery cell is performed according to the set 314 of individual charging time periods, which is the first individual charging time period set determined in the previous example embodiment. Graphs 411 included in the graph chart 401 of charging current over time and graphs 412 included in the graph chart 402 of the charging current over the SoC of the battery cell may represent a case where charging is performed with corresponding charging currents according to the set 314 of individual charging time periods, which is the first individual charging time period set as in the previous example, but the order of the corresponding charging currents is arbitrarily changed. In this case, the total time required from the SoC when fast charging was first started to the SoC when the fast charging was stopped, and the full charge capacity charged may be the same for all graphs.

Referring to FIG. 4b, the electronic device 100 according to an example embodiment may determine the charging order in the order of the charging current set corresponding to the minimum number of times that the anode voltage of the battery cell satisfies the threshold voltage in the entire charging process according to the charging current value corresponding to the first individual charging time period set. For example, the electronic device 100 according to an example embodiment may determine the charging order in which the number of times the anode voltage reaches (violates) the threshold voltage (for example, 0 V) in the entire charging process among multiple charging order cases is minimized as the charging order of the plurality of charging currents. For example, when charging is performed with a charging order case 413 among all charging order cases as shown in a chart 403 of FIG. 4b, identified is the number of reach (the violation number) between the anode voltage and the threshold voltage is minimum. Therefore, the electronic device 100 according to an example embodiment may determine the charging order in the order of the charging current set corresponding to the charging order case 413.

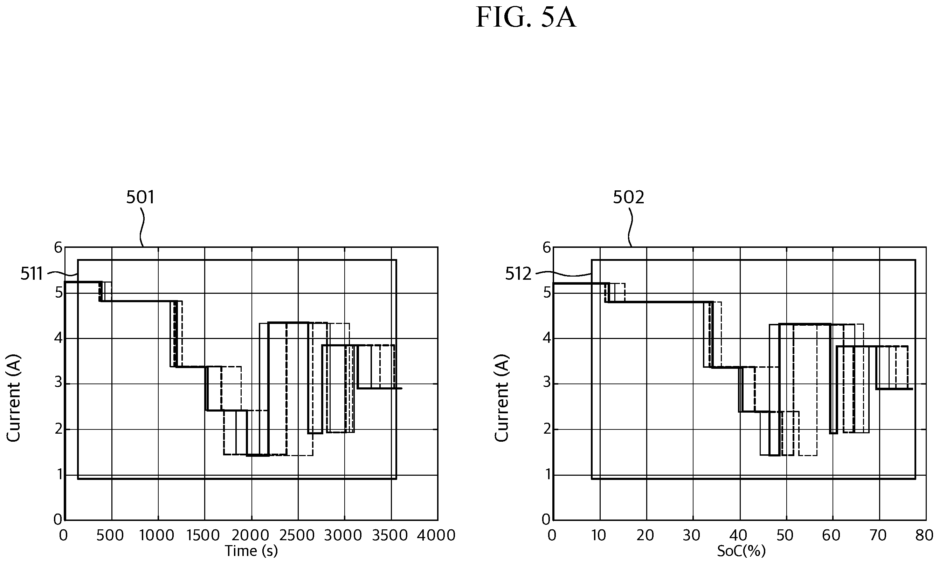

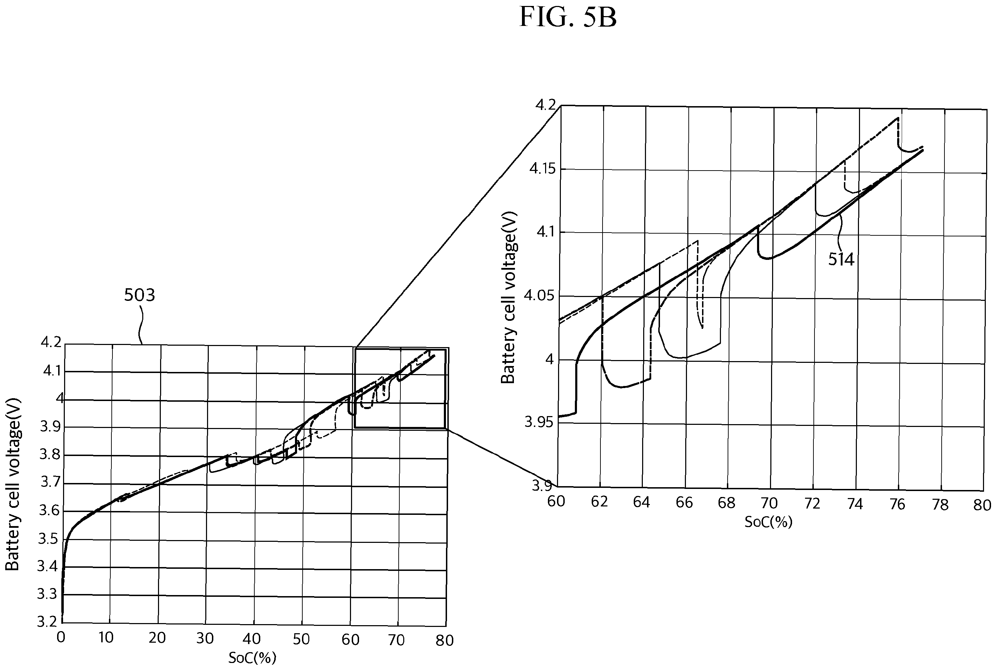

FIG. 5a and FIG. 5b are drawings for explaining operations of determining a charging order and a second individual charging time period set as a fast charging pattern of a battery cell in a method of determining a fast charging pattern of a battery cell, according to an example embodiment.

Referring to FIG. 5a with respect to operation S240 described with reference to FIG. 2 and FIG. 4b, identified are a graph chart 501 of charging current over time and a graph chart 502 of charging current according to the SoC of a battery cell when the fast charging of the battery cell is performed according to the charging order case 413 determined as in the previous example embodiment. Graphs 511 included in the graph chart 501 of charging current over time and graphs 512 included in the graph chart 502 of charging current over the SoC of the battery cell may represent a case in which charging is performed in the order of charging current according to the charging order case 413 as in the previous example embodiment, but charging is performed by arbitrarily changing the individual charging time period corresponding to each of a plurality of charging currents. In this case, the total time, which is time from the SoC when fast charging was first started to the SoC when fast charging was ended, and full charge capacity charged may be the same for all graphs.

Referring to FIG. 5b, after the fast charging is completed according to the charging order based on the charging order case 413, the electronic device 100 according to an example embodiment may determine a set of individual charging time periods that minimizes the increase in battery cell voltage during the entire charging process as the second individual charging time period set. For example, when the fast charging is performed with a plurality of individual charging time periods corresponding to each of the plurality of charging currents according to the charging order based on the charging order case 413 as shown in a chart 503 of FIG. 5b, identified is a graph 514 which illustrates the lowest increase in the battery cell voltage. The lowest increase in battery cell voltage after fast charging means that the lowest decrease in the anode voltage of the battery cell after fast charging, and this indicates that the battery degradation is minimal, and thus the electronic device 100 may determine the set of individual charging time periods used in the graph 514 as the second individual charging time period set. After then, the electronic device 100 may determine the charging order based on the charging order case 413 and the second individual charging time period set determined previously as the fast charging pattern of the battery cell.

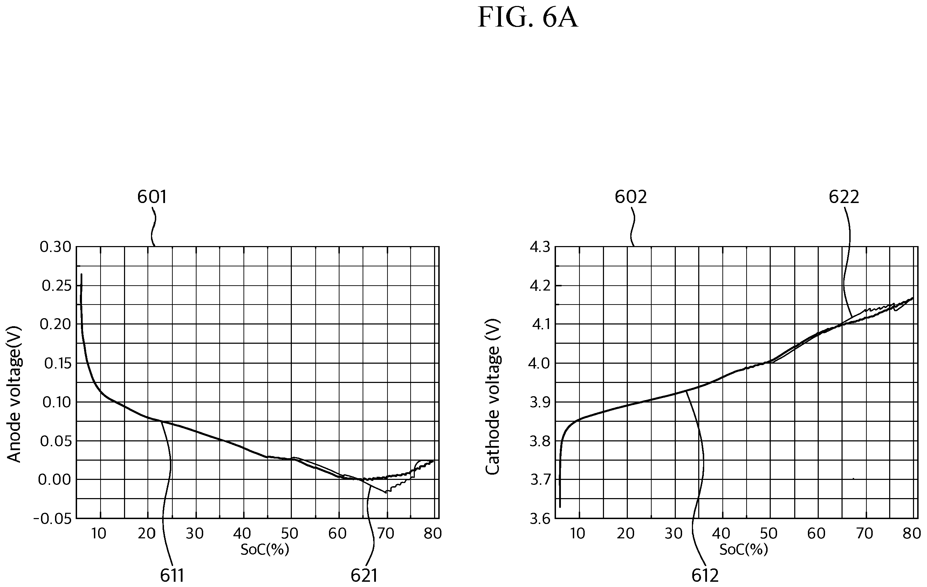

FIG. 6a to FIG. 6c are drawings for explaining the effect of a method for determining a fast charging pattern of a battery cell according to an example embodiment.

Referring to FIG. 6a, the electronic device 100 according to an example embodiment may determine the fast charging pattern through the process described above. Identified are a graph chart 601 of the anode voltage of the battery cell according to the SoC when the fast charging is performed according to the fast charging pattern and a graph chart 602 of the anode voltage of the battery cell according to the SoC.

When a first fast charging pattern graph 611 and a second fast charging pattern graph 621 included in the graph chart 601 of the anode voltage of the battery cell are compared, identified is that, in the case of the second fast charging pattern graph 621, compared to the first fast charging pattern graph 611, as the SoC increases through fast charging, the number of times the anode voltage comes into contact with the threshold voltage described above is smaller, and the decrease in the anode voltage throughout the entire charging process is smaller. Further, when a first fast charging pattern graph 612 and a second fast charging pattern graph 622 included in the graph chart 602 of the cathode voltage of the battery cell are compared, identified is that, in the case of the second fast charging pattern graph 622, compared to the first fast charging pattern graph 612, the increase in the cathode voltage throughout the entire charging process is smaller as the SoC increases through the fast charging. Through this, it is identified that the degree of increase in battery cell voltage is less when following the second fast charging pattern than when following the first fast charging pattern, and identified is that the second fast charging pattern is a fast charging pattern that is closer to optimization than the first fast charging pattern.

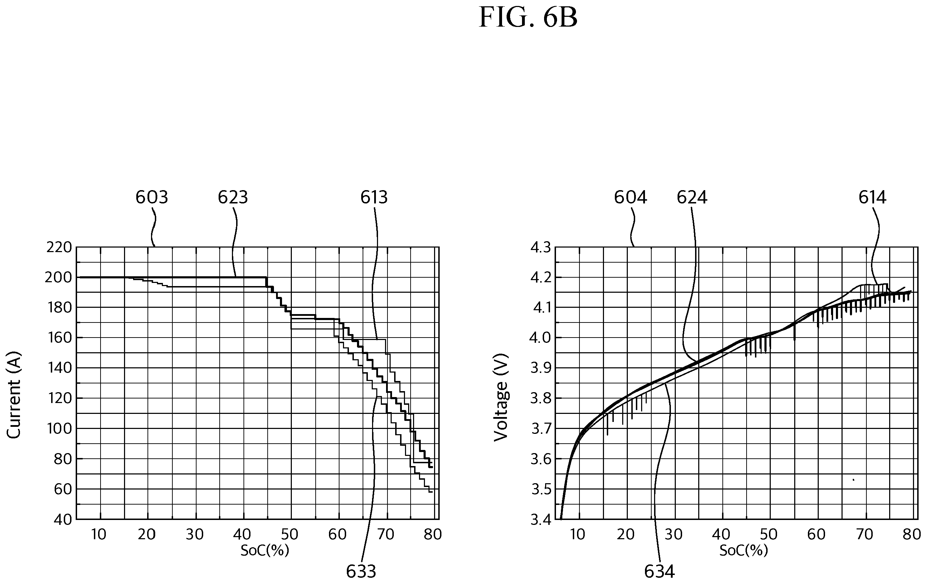

Referring to FIG. 6b, identified is a graph chart 603 of charging current according to the SoC of the battery cell and a graph chart 604 of the battery cell voltage according to the SoC when fast charging is performed according to a fast charging pattern determined according to an example embodiment. Identified are a first fast charging pattern graph 613, a second fast charging pattern graph 623 and a general fast charging pattern graph 633 included in the graph chart 603 of charging current according to the SoC of the battery cell, and compared are a voltage change graph 614 of the battery cell according to the first fast charging pattern, a voltage change graph 624 of the battery cell according to the second fast charging pattern, and a voltage change graph 634 of the battery cell according to the general pattern included in the graph chart 604 of the voltage of the battery cell according to the SoC. In this case, charging according to the normal fast charging pattern takes about 21.6 minutes, but according to example embodiments of the present disclosure, the entire charging process takes approximately 19.3 minutes. Referring to the voltage change graph 624 of the battery cell according to the second fast charging pattern, identified is that the voltage increase of the battery cell is small, compared to another graph (the voltage change graph 614 ) and the graph (the voltage change graph 634).

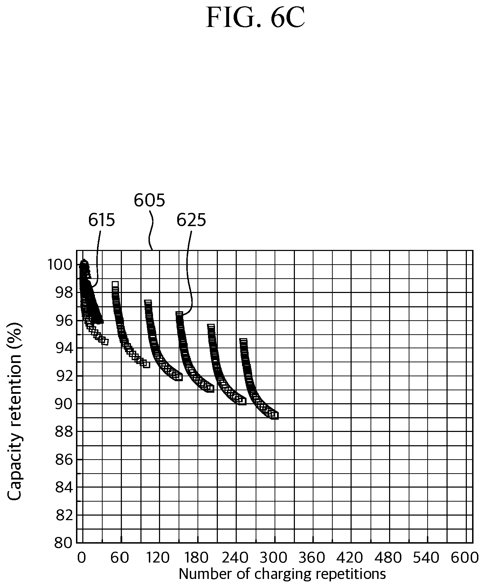

Referring to FIG. 6c, identified is a chart 605 on capacity retention according to the number of charging repetitions in a fast charging pattern. When comparing a graph 615 according to a second fast charging pattern and a graph 625 according to the normal charging pattern, which are included in the chart 605 on capacity retention according to the number of charging repetitions of the fast charging pattern, identified is that the degree of decrease in the capacity retention of the battery cell according to the same number of charging repetitions is less in the graph 615 according to the second fast charging pattern than in the graph 625 according to the normal charging pattern.

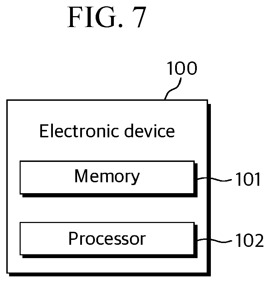

FIG. 7 is a block diagram showing the configuration of an electronic device that determines the impedance of a battery cell according to an example embodiment.

FIG. 7 illustrates a block diagram of an electronic device according to an example embodiment. According to an example embodiment, the electronic device 100 may include a memory 101 and a processor 102. The electronic device 100 illustrated in FIG. 7 illustrates only the elements relevant to this example embodiment. Therefore, it will be apparent to those skilled in the art that other general elements may be included in addition to the elements illustrated in FIG. 7, as described herein.

As a hardware that stores various data processed within the electronic device 100, the memory 101 according to an example embodiment may be located within the processor 102 in the electronic device 100 and may store data processed and data to be processed through the processor 102. Further, the memory may store not only basic programming and data structures that may provide the functionality of at least one example embodiment of the present disclosure but also applications (programs, code modules and commands) and drivers that may provide the functionality of example embodiments of the present disclosure. The memory may include random access memory (RAM), such as dynamic random access memory (DRAM), static random access memory (SRAM), read-only memory (ROM), electrically erasable programmable read-only memory (EEPROM), CD-ROM, Blu-ray and other optical disk storage, hard disk drive (HDD), solid state drive (SSD) or flash memory. However, example embodiment of the present disclosure is not limited thereto.

In an example embodiment, the processor 102 may be included in a controller. The processor 102 may control the overall operation of the electronic device 100 and may process data and signals. The processor 102 may consist of at least one hardware unit. Further, the processor 102 may be operated by one or more software modules generated by executing program code stored in the memory 101. Since the processor 102 may include memory, the processor 102 may execute program code stored in the memory to control the overall operation of the electronic device 100 and process data and signals.

The processor 102 may be configured to set charging conditions including a charging current set including a plurality of charging currents of the battery cell, full charge capacity of the battery cell and total charge time of the battery cell, determine a first individual charging time period set including a plurality of individual charging time periods corresponding to each of the plurality of charging currents satisfying the charging conditions, determine a charging order of the plurality of charging currents corresponding to the first individual charging time period set, based on the charging order of the plurality of charging currents, determine a second individual charging time period set including a plurality of individual charging time periods in which a voltage increase value of the battery cell becomes minimum, and determine the charging order and the second individual charging time period set as a fast charging pattern of the battery cell.

The processor 102 according to an example embodiment may be set to perform determining as the charging order an order of a charging current set in which a number of times the anode voltage of the battery cell satisfies is minimum a threshold voltage in the entire charging process according to a charging current value corresponding to the first individual charging time period set.

The processor 102 according to an example embodiment may be set to further perform, after charging is performed according to the fast charging pattern of the battery cell, obtaining information on capacity degradation of the battery cell and information on increase of internal resistance of the battery cell.

The processor 102 according to an example embodiment may be set to further perform, based on the information on the capacity degradation of the battery cell and the information on increase of the internal resistance of the battery cell, setting charging conditions including a charging current set including the plurality of charging currents of the battery cell after charging is performed, full charge capacity of the battery cell after the charging is performed and total charge time of the battery cell after the charging is performed, determining a third individual charging time period set including a plurality of individual charging time periods corresponding to each of the plurality of charging currents satisfying the charging conditions, determining a charging order of the plurality of charging currents corresponding to the third individual charging time period set, based on the charging order of the plurality of charging currents, determining a fourth individual charging time period set in which a charging voltage of the battery cell after the charging is performed becomes minimum and that includes a plurality of individual charging time periods, and determining the charging order and the fourth individual charging time period set as a fast charging pattern of the battery cell after the charging is performed.

The processor 102 according to an example embodiment may be set to further perform generating a matrix of which elements are values of the plurality of charging currents and a matrix of which elements are a value of the full charge capacity and a value of the total charge time, and arbitrarily changing an order of each element of the matrix of which elements are the values of the plurality of charging currents, and determining first charging currents sets including a plurality of individual charging time periods corresponding to each charging current of a changed order.

The processor 102 according to an example embodiment may be set to in order for each of the plurality of charging currents included in the charging current set to have a different value.

According to an example embodiment, the electronic device 100 may additionally include a transceiver for performing wired/wireless communication. The electronic device 100 may communicate with an external electronic device (for example, the battery management device 200) using a transceiver. The external electronic device may be a terminal or a server. Further, the communication technologies used by a communication (GSM), Code Division Multi Access (CDMA), Long Term Evolution (LTE), 5G, Wireless LAN (WLAN), Wireless-Fidelity (Wi-Fi), Bluetooth™, Radio Frequency Identification (RFID), Infrared Data Association (IrDA), ZigBee, Near Field Communication (NFC) and so on.

The electronic device according to the above-described example embodiments may include a processor, a memory for storing and executing program data, a permanent storage such as a disk drive, and/or a user interface device such as a communication port, a touch panel, a key and/or a button that communicates with an external device. Methods implemented as software modules or algorithms may be stored in a computer-readable recording medium as computer-readable codes or program instructions executable on the processor. Here, the computer-readable recording medium includes a magnetic storage medium (for example, ROMs, RAMs, floppy disks and hard disks) and an optically readable medium (for example, CD-ROMs and DVDs). The computer-readable recording medium may be distributed among network-connected computer systems, so that the computer-readable codes may be stored and executed in a distributed manner. The medium may be readable by a computer, stored in a memory, and executed on a processer.

The example embodiments may be represented by functional block elements and various processing steps. The functional blocks may be implemented in any number of hardware and/or software configurations that perform specific functions. For example, an example embodiment may adopt integrated circuit configurations, such as memory, processing, logic and/or look-up table, that may execute various functions by the control of one or more microprocessors or other control devices. Similar to that elements may be implemented as software programming or software elements, the example embodiments may be implemented in a programming or scripting language such as C, C++, C#, Java, assembler, etc., including various algorithms implemented as a combination of data structures, processes, routines, or other programming constructs. Functional aspects may be implemented in an algorithm running on one or more processors. Functional aspects may be implemented in an algorithm running on one or more processors. Further, the example embodiments may adopt the existing art for electronic environment setting, signal processing, and/or data processing. Terms such as "mechanism," "element," "means" and "configuration" may be used broadly and are not limited to mechanical and physical elements. The terms may include the meaning of a series of routines of software in association with a processor or the like.

The above-described example embodiments are merely examples, and other embodiments may be implemented within the scope of the claims to be described later.

**Claims**

1.   A method of determining a fast charging pattern of a battery cell, the method comprising:

setting, by an electronic device, charging conditions comprising a charging current set comprising a plurality of charging currents of the battery cell, a full charge capacity of the battery cell and a total charge time of the battery cell;
determining a first individual charging time period set comprising a plurality of individual charging time periods corresponding to each of the plurality of charging currents satisfying the charging conditions;
determining a charging order of the plurality of charging currents corresponding to the first individual charging time period set;
based on the charging order of the plurality of charging currents, determining a second individual charging time period set comprising a plurality of individual charging time periods in which a voltage increase value of the battery cell after charging becomes minimum; and
determining the charging order and the second individual charging time period set as a fast charging pattern of the battery cell.

2.   The method of claim 1, wherein the determining the first individual charging time period set comprises:

obtaining a set of the plurality of individual charging time periods in order for a value, which is obtained by adding values obtained by multiplying a predetermined charging current included in the plurality of charging currents of the battery cell and a predetermined charging time period corresponding to the predetermined charging current, to be equal to the full charge capacity of the battery cell, and in order for a sum of predetermined charging time periods to be equal to the total charge time of the battery cell; and
determining a set of individual charging time periods in which a minimum number of times an anode voltage of the battery cell satisfies a threshold voltage in an entire charging process, from sets of the plurality of individual charging time periods.

3.   The method of claim 1, wherein the determining the charging order of the plurality of charging currents corresponding to the first individual charging time period set comprises, determining as the charging order, an order of a charging current set in which a number of times an anode voltage of the battery cell satisfies is minimum a threshold voltage in an entire charging process according to a charging current value corresponding to the first individual charging time period set.

4.   The method of claim 1, further comprising, after charging is performed according to the fast charging pattern of the battery cell, obtaining information on capacity degradation of the battery cell and information on increase of internal resistance of the battery cell.

5.   The method of claim 4, further comprising:

based on the information on the capacity degradation of the battery cell and the information on the increase of the internal resistance of the battery cell, setting charging conditions comprising the charging current set comprising the plurality of charging currents of the battery cell after charging is performed, the full charge capacity of the battery cell after the charging is performed and the total charge time of the battery cell after the charging is performed;
determining a third individual charging time period set comprising a plurality of individual charging time periods corresponding to each of the plurality of charging currents satisfying the charging conditions;
determining a charging order of the plurality of charging currents corresponding to the third individual charging time period set;
based on the charging order of the plurality of charging currents, determining a fourth individual charging time period set in which a charging voltage of the battery cell after the charging is performed becomes minimum and that comprises a plurality of individual charging time periods; and
determining the charging order and the fourth individual charging time period set as a fast charging pattern of the battery cell after the charging is performed.

6. The method of claim 1, wherein the setting the charging conditions comprises generating a matrix of which elements are values of the plurality of charging currents and a matrix of which elements are a value of the full charge capacity and a value of the total charge time, and
wherein determining first individual charging time period set comprises arbitrarily changing an order of each element of the matrix of which elements are the values of the plurality of charging currents, and determining the first individual charging time period set comprising a plurality of individual charging time periods corresponding to each charging current of a changed order.

7. The method of claim 6, wherein each of the plurality of charging currents included in the charging current set comprises a different value.

8. The method of claim 1, wherein the charging conditions are determined based on at least one of internal temperature of the battery cell, an initial state of charge (SoC) of the battery cell, and internal resistance of the battery cell.

9. A non-transitory computer-readable recording medium having a program for executing the method of claim I on a computer.

10. An electronic device for performing a method of determining a fast charging pattern of a battery cell, the electronic device comprising:

    a memory configured to store instructions; and
    a processor connected to the memory,
    wherein the processor is configured to:

        set charging conditions comprising a charging current set comprising a plurality of charging currents of the battery cell, full charge capacity of the battery cell and total charge time of the battery cell;
        determine a first individual charging time period set comprising a plurality of individual charging time periods corresponding to each of the plurality of charging currents satisfying the charging conditions;
        determine a charging order of the plurality of charging currents corresponding to the first individual charging time period set;
        based on the charging order of the plurality of charging currents, determine a second individual charging time period set comprising a plurality of individual charging time periods in which a voltage increase value of the battery cell becomes minimum; and
        determine the charging order and the second individual charging time period set as a fast charging pattern of the battery cell.

# FIG. 1

| Electronic device | | Battery management device | | Battery cell |
|---|---|---|---|---|
| 100 | ↔ | 200 | ↔ | 300 |

# FIG. 2

```
                    ┌─────────────┐
                    │    Start    │
                    └──────┬──────┘
                           │
                           ▼
   ┌───────────────────────────────────────────────┐
   │  Set charging condition including charging     │
   │  current set including plurality of charging   │
   │  currents of battery cell, full charge         │── S210
   │  capacity of battery cell and total charge     │
   │  time of battery cell                          │
   └───────────────────────┬───────────────────────┘
                           │
                           ▼
   ┌───────────────────────────────────────────────┐
   │  Determine first individual charging time      │
   │  period set including plurality of individual  │
   │  charging time periods corresponding to each   │── S220
   │  of plurality of charging currents that        │
   │  satisfy charging conditions                   │
   └───────────────────────┬───────────────────────┘
                           │
                           ▼
   ┌───────────────────────────────────────────────┐
   │  Determine charging order of plurality of      │
   │  charging currents corresponding to first      │── S230
   │  individual charging time period set           │
   └───────────────────────┬───────────────────────┘
                           │
                           ▼
   ┌───────────────────────────────────────────────┐
   │  Based on charging order of plurality of       │
   │  charging currents, determine second           │
   │  individual charging time period set including │── S240
   │  plurality of individual charging time periods │
   │  in which voltage increase value of battery    │
   │  cell is minimized                             │
   └───────────────────────┬───────────────────────┘
                           │
                           ▼
   ┌───────────────────────────────────────────────┐
   │  Determine charging order and second           │
   │  individual charging time period set as fast   │── S250
   │  charging pattern of battery cell              │
   └───────────────────────┬───────────────────────┘
                           │
                           ▼
                    ┌─────────────┐
                    │    End      │
                    └─────────────┘
```

FIG. 3A

FIG. 3B

303

304

314

EP 4 769 879 A1

FIG. 4A

EP 4 769 879 A1

# FIG. 4B

# FIG. 5A

## FIG. 5B

FIG. 6A

# FIG. 6B

EP 4 769 879 A1

# FIG. 6C

# FIG. 7

Electronic device

Memory — 101

Processor — 102

100

## INTERNATIONAL SEARCH REPORT

| International application No. |
| --- |
| **PCT/KR2024/017274** |

**A. CLASSIFICATION OF SUBJECT MATTER**

**H02J 7/00**(2006.01)i; **G01R 31/396**(2019.01)i; **G01R 31/392**(2019.01)i

According to International Patent Classification (IPC) or to both national classification and IPC

**B. FIELDS SEARCHED**

Minimum documentation searched (classification system followed by classification symbols)

H02J 7/00(2006.01); B60L 58/12(2019.01); B60L 58/16(2019.01); G01R 31/36(2006.01); G01R 31/392(2019.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 셀(battery cell), 충전 시간(charging time), 음극 전압(anode voltage), 전류 세트(current set), 순서(sequence)

**C. DOCUMENTS CONSIDERED TO BE RELEVANT**

| Category* | Citation of document, with indication, where appropriate, of the relevant passages | Relevant to claim No. |
| --- | --- | --- |
| Y | KR 10-2554151 B1 (SAMSUNG ELECTRONICS CO., LTD.) 12 July 2023 (2023-07-12) paragraphs [0006]-[0105]; and figures 1-9 | 1-5,8-10 |
| A | | 6-7 |
| Y | KR 10-2022-0169197 A (SAMSUNG ELECTRONICS CO., LTD.) 27 December 2022 (2022-12-27) paragraph [0014]; and figures 1-3 | 1-5,8-10 |
| A | KR 10-2018-0048281 A (SAMSUNG ELECTRONICS CO., LTD.) 10 May 2018 (2018-05-10) paragraphs [0073]-[0077]; and figure 5 | 1-10 |
| A | KR 10-2023-0117193 A (CONTEMPORARY AMPEREX TECHNOLOGY CO., LIMITED) 07 August 2023 (2023-08-07) paragraphs [0045]-[0051]; and figure 2 | 1-10 |
| A | KR 10-2021-0028476 A (SAMSUNG ELECTRONICS CO., LTD. et al.) 12 March 2021 (2021-03-12) paragraphs [0087]-[0093]; and figure 7 | 1-10 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **13 March 2025** | **13 March 2025** |

| Name and mailing address of the ISA/KR | Authorized officer |
| --- | --- |
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/017274**

| Patent document cited in search report | | | Publication date (day/month/year) | Patent family member(s) | | | Publication date (day/month/year) |
|---|---|---|---|---|---|---|---|
| KR | 10-2554151 | B1 | 12 July 2023 | CN | 109698531 | A | 30 April 2019 |
| | | | | CN | 109698531 | B | 28 November 2023 |
| | | | | EP | 3477813 | A1 | 01 May 2019 |
| | | | | EP | 3477813 | B1 | 21 April 2021 |
| | | | | JP | 2019-079794 | A | 23 May 2019 |
| | | | | JP | 7249754 | B2 | 31 March 2023 |
| | | | | KR | 10-2019-0045736 | A | 03 May 2019 |
| | | | | US | 10720786 | B2 | 21 July 2020 |
| | | | | US | 11088558 | B2 | 10 August 2021 |
| | | | | US | 2019-0123574 | A1 | 25 April 2019 |
| | | | | US | 2020-0335993 | A1 | 22 October 2020 |
| KR | 10-2022-0169197 | A | 27 December 2022 | CN | 115498715 | A | 20 December 2022 |
| | | | | EP | 4106134 | A1 | 21 December 2022 |
| | | | | US | 2022-0407324 | A1 | 22 December 2022 |
| KR | 10-2018-0048281 | A | 10 May 2018 | CN | 108023375 | A | 11 May 2018 |
| | | | | CN | 108023375 | B | 02 February 2024 |
| | | | | EP | 3316446 | A1 | 02 May 2018 |
| | | | | EP | 3316446 | B1 | 23 September 2020 |
| | | | | JP | 2018-082613 | A | 24 May 2018 |
| | | | | JP | 7076191 | B2 | 27 May 2022 |
| | | | | KR | 10-2455631 | B1 | 18 October 2022 |
| | | | | US | 10985590 | B2 | 20 April 2021 |
| | | | | US | 11929468 | B2 | 12 March 2024 |
| | | | | US | 2018-0123354 | A1 | 03 May 2018 |
| | | | | US | 2021-0210971 | A1 | 08 July 2021 |
| KR | 10-2023-0117193 | A | 07 August 2023 | CN | 116508224 | A | 28 July 2023 |
| | | | | EP | 4254597 | A1 | 04 October 2023 |
| | | | | EP | 4254597 | A4 | 08 May 2024 |
| | | | | JP | 2024-503009 | A | 24 January 2024 |
| | | | | JP | 7590586 | B2 | 26 November 2024 |
| | | | | KR | 10-2772600 | B1 | 24 February 2025 |
| | | | | US | 2024-0022092 | A1 | 18 January 2024 |
| | | | | WO | 2023-092413 | A1 | 01 June 2023 |
| KR | 10-2021-0028476 | A | 12 March 2021 | CN | 112448055 | A | 05 March 2021 |
| | | | | EP | 3790153 | A1 | 10 March 2021 |
| | | | | JP | 2021-040476 | A | 11 March 2021 |
| | | | | JP | 7616841 | B2 | 17 January 2025 |
| | | | | US | 12081058 | B2 | 03 September 2024 |
| | | | | US | 2021-0066945 | A1 | 04 March 2021 |

Form PCT/ISA/210 (patent family annex) (July 2022)